# EUROPÄISCHE PATENTSCHRIFT

(11) **EP 4 234 519 B1**
(45) Veröffentlichungstag und Bekanntmachung des Hinweises auf die Patenterteilung: **29.07.2026**
(21) Anmeldenummer: 23175217.1
(22) Anmeldetag: 13.05.2020
(51) Int. Cl.: C04B 37/02, B23K 1/00, H05K 3/40

(54) **VERFAHREN ZUR HERSTELLUNG EINES METALL-KERAMIK-SUBSTRATS**
METHOD FOR PRODUCING A METAL-CERAMIC SUBSTRATE
PROCÉDÉ DE PRODUCTION D'UN SUBSTRAT MÉTAL-CÉRAMIQUE

(30) Priorität: 20.05.2019 DE 102019113308
(43) Veröffentlichungstag der Anmeldung: 30.08.2023
(62) Teilanmeldung aus: 20727939.9
(73) Patentinhaber: Rogers Germany GmbH, 92676 Eschenbach (DE)
(72) Erfinder: Meyer, Andreas, 95469 Speichersdorf (DE)
(74) Vertreter: Müller Schupfner & Partner Patent- und Rechtsanwaltspartnerschaft mbB (Muc)

(56) Entgegenhaltungen:
- WO-A1-2018/114884
- WO-A2-2014/008891
- DE-A1- 102007 030 389
- DE-A1- 2 508 224
- DE-A1- 4 318 463

## Beschreibung

Die vorliegende Erfindung betrifft ein Verfahren zur Herstellung eines Metall-Keramik-Substrats.

Metall-Keramik-Substrate sind beispielsweise als Leiterplatten oder Platinen aus dem Stand der Technik hinlänglich bekannt, beispielsweise aus der DE 10 2013 104 739 A1, der DE 19 927 046 B4 und der DE 10 2009 033 029 A1. Typischerweise werden auf einer Bauteilseite des Metall-Keramik-Substrats Anschlussflächen für elektrische Bauteile und Leiterbahnen angeordnet, wobei die elektrischen Bauteile und die Leiterbahnen zu elektrischen Schaltkreisen zusammenschaltbar sind. Wesentliche Bestandteile der Metall-Keramik-Substrate sind eine Isolationsschicht, die bevorzugt aus einer Keramik gefertigt ist, und eine an die Isolationsschicht angebundene Metallschicht. Wegen ihren vergleichsweise hohen Isolationsfestigkeiten haben sich aus Keramik gefertigte Isolationsschichten in der Leistungselektronik als besonders vorteilhaft erwiesen. Durch eine Strukturierung der Metallschicht können sodann Leiterbahnen und/oder Anschlussflächen für die elektrischen Bauteile realisiert werden.

Insbesondere betrifft die vorliegende Anmeldung Metall-Keramik-Substrate, an denen zumindest ein Metallabschnitt vorgesehen sind, der in einer parallel zur Haupterstreckungsebene verlaufenden Richtung gegenüber der Keramikschicht, insbesondere dessen äußersten Rand, vorsteht und dadurch einen seitlichen bzw. lateralen Anschluss bzw. Terminal für das Metall-Keramik-Substrat bereitstellt.

Für die Herstellung solcher Terminals sieht es der Stand der Technik vor, dass Terminalbereiche nach der Strukturierung der Metallschicht mechanisch durch ein Abziehen der bereits an die Keramikschicht angebundenen Metallschicht realisiert werden. Dadurch können nur vergleichsweise kleine Terminals erzeugt werden.

Zudem ist ein erheblicher Kraftaufwand erforderlich und die Ausbeute funktionsfähiger Metall-Keramik-Substrate mit dem gewünschten Terminal ist vergleichsweise gering.

Alternativ ist es aus dem Stand der Technik bekannt, die Terminals unter Verwendung einer sogenannten Streifentechnik zu realisieren. Allerdings werden hierbei keine Metall-Keramik-Substrate in einem Großkartenformat hergestellt, sondern auf einzelnen Keramikabschnitten werden Metallschichten angebunden, die breiter sind als die Keramikschicht. Eine solche Herstellung lässt sich allerdings nur schwer automatisieren und ist nicht effizient.

WO2014008891 zeigt ein Metall-Keramik-Substrat.

Aus der DE 10 2007 030 389 A1 ist eine Keramikschicht bekannt, die mit einem metallischen Kühlkörper verbunden ist. Eine Lotschicht verbindet die zwei Körper. Dabei sind Keramikschicht und Metallschicht nicht überall stoffschlüssig miteinander verbunden.

Ausgehend von diesem Stand der Technik macht es sich die vorliegende Erfindung zur Aufgabe, ein gegenüber dem Stand der Technik verbessertes Verfahren bereitzustellen, mit dem Metall-Keramik-Substrate, die einen seitlich über die Keramikschicht überstehenden Metallabschnitt aufweisen, realisiert werden können, insbesondere in Hinblick auf eine verbesserte Effizienz und Ausbeute bei der Herstellung solcher Metall-Keramik-Substrate.

Diese Aufgabe wird durch ein Verfahren zur Herstellung eines Metall-Keramik-Substrats gemäß Anspruch 1. Weitere Vorteile und Eigenschaften ergeben sich aus den Unteransprüchen sowie der Beschreibung und den beigefügten Figuren.

Gemäß einem ersten Aspekt der vorliegenden Erfindung ist ein Verfahren zur Herstellung eines Metall-Keramik-Substrats vorgesehen, das im gefertigten Zustand eine Keramikschicht und eine Metallschicht, die sich entlang einer Haupterstreckungsebene erstrecken und entlang einer senkrecht zur Haupterstreckungsebene verlaufenden Stapelrichtung übereinander angeordnet sind, aufweist, umfassend
-- Bereitstellen der Metallschicht und der Keramikschicht und
-- bereichsweises Anbinden der Metallschicht an die Keramikschicht zur Ausbildung eines ersten Bereichs, der eine stoffschlüssige Verbindung zwischen der Metallschicht und der Keramikschicht aufweist, und eines zweiten Bereichs, in dem die Metallschicht und die Keramikschicht ohne stoffschlüssige Verbindung in Stapelrichtung gesehen übereinander angeordnet sind, wobei der zweite Bereich zumindest bereichsweise als Anschlussfläche und/oder als Terminal bereitgestellt wird. Vorzugsweise umfasst das Verfahren die Schritte:
   - Auftrennen der Keramikschicht im zweiten Bereich in einem parallel zur Haupterstreckungsebene bemessenen ersten Abstand vom ersten Bereich und
   - Auftrennen der Metallschicht im zweiten Bereich in einem in einem parallel zur Haupterstreckungsebene bemessenen zweiten Abstand vom ersten Bereich.

Gegenüber den aus dem Stand der Technik bekannten Verfahren wird erfindungsgemäß auf ein Abziehen der Metallschicht zur Bildung eines seitlich vorstehenden Terminals bzw. auf ein sogenanntes Streifenverfahren verzichtet. Stattdessen ist es erfindungsgemäß vorgesehen, in einem zweiten Bereich auf eine stoffschlüssige Verbindung zwischen der Metallschicht und der Keramikschicht im Anbindungsprozess zu verzichten, sodass eine entsprechende Auftrennung der Metallschicht auf der einen Seite und der Keramikschicht auf der anderen Seite dazu genutzt werden kann, dass sich die Keramikschicht und die Metallschicht entlang einer parallel zur Haupterstreckungsebene HSE verlaufenden Richtung unterschiedlich weit vom ersten Bereich erstrecken können. Dies gestattet es insbesondere, dass der äußerste Bereich der Metallschicht einen Metallabschnitt bildet, der als seitlicher Terminal bzw. Anschluss genutzt werden kann und der dabei bevorzugt über einen Rand der Keramikschicht in einer parallel zur Haupterstreckungsebene verlaufenden Richtung übersteht. Es ist aber auch vorgesehen, dass der den äußersten Bereich der Metallschicht bildende Metallabschnitt bündig mit dem Rand der Keramikschicht abschließt oder sogar diesbezüglich zurückversetzt ist, d. h. die Keramikschicht steht gegenüber der Metallschicht vor. Durch ein anschließendes Biegen, insbesondere Nach-Oben-Biegen, des Metallabschnitts ist es dann in vorteilhafter Weise möglich, seitliche Terminals bereitzustellen, die schräg zur Haupterstreckungsebene abstehen.

Vorzugsweise umfasst das Verfahren die Schritte:
- Auftrennen der Keramikschicht im zweiten Bereich in einem parallel zur Haupterstreckungsebene bemessenen ersten Abstand vom ersten Bereich oder
- Auftrennen der Metallschicht im zweiten Bereich in einem in einem parallel zur Haupterstreckungsebene bemessenen zweiten Abstand vom ersten Bereich.

Alternativ ist es vorstellbar, dass der zweite Bereich einen innenliegenden Metallbereich der Metallschicht betrifft, insbesondere ohne Auftrennen der Metallschicht im zweiten Bereich. Durch das Vermeiden einer stoffschlüssigen Verbindung im zweiten Bereich, wird eine Art Brücke zwischen einzelnen ersten Bereichen gebildet, wobei sich der zweite Bereich in dieser Form als besonders vorteilhaft für die Ausbildung als Anbindungsfläche für elektronische Bauteile erwiesen hat, da dadurch eine bereichsweise mechanische Entkopplung zwischen Metallschicht und Keramikschicht möglich ist, mit der, insbesondere bei einzelnen Anbindungsmethoden, wie dem Reibschweißen, die Wahrscheinlichkeit für andernfalls auftretende Schädigung am Metall-Keramik-Substrat reduziert werden kann. Dabei kann der zweite Bereich vorzugsweise vollständig geschlossen sein. Alternativ umfasst der innenliegende zweite Bereich eine Öffnung, beispielsweise realisiert durch ein Ätzen, wodurch ein Aufbiegen bzw. Hochbiegen eines Teilbereichs des zweiten Bereichs gestattet, wodurch ein schräg zur Haupterstreckungsebene abstehender Terminal, insbesondere im innenliegenden Metallbereich, realisiert werden kann.

Insbesondere wird als innenliegender Metallbereich ein solcher Abschnitt verstanden, an den sich in alle parallel zur Haupterstreckungsebene verlaufenden Richtungen Metall der Metallschicht anschließt. Es handelt sich somit bei dem innenliegenden Metallbereich nicht um einen Randbereich der Metallschicht, der eine außenliegende Kante der Metallschicht umfasst.

Weiterhin ist es bevorzugt vorgesehen, dass der zweite Bereich nicht durch ein Abheben bzw. Abziehen der Metallschicht von dem Keramikelement nach dem Anbinden der Metallschicht an das Keramikelement erfolgt. Mit anderen Worten: der zweite Bereich ohne stoffschlüssige Verbindung wird ohne ein Abziehen oder Abheben, d. h. ohne eine Zugkraft, die auf die Metallschicht und/oder Keramikschicht wirkt, gebildet. Insbesondere ist es vorgesehen, dass der zweite Bereich zeitlich vor dem Auftrennen der Metallschicht und/oder der Keramikschicht und/oder zeitlich vor dem Strukturieren der Metallschicht gebildet wird.

Vorzugsweise ist es vorgesehen, dass das gefertigte Metall-Keramik-Substrat einen zweiten Bereich aufweist. Mit anderen Worten: Es gibt im gefertigten Metall-Keramik-Substrat bevorzugt zumindest einen Teilabschnitt, in dem in Stapelrichtung gesehen ein Abschnitt der Metallschicht oberhalb der Keramikschicht angeordnet ist, ohne dass dieser Abschnitt eine stoffschlüssige Verbindung mit der Keramikschicht ausbildet. Dieser Bereich wird dann als Terminal genutzt.

Weiterhin ist es bevorzugt vorgesehen, dass gleichzeitig mit dem Auftrennen der Metallschicht im zweiten Bereich eine Strukturierung von der Metallschicht vorgenommen wird. Dies erweist sich insbesondere deshalb als vorteilhaft, weil aufgrund der fehlenden stoffschlüssigen Anbindung hier auf ein sogenanntes "second etching" verzichtet werden kann, das andernfalls erforderlich wäre, um eine Bindungsschicht zwischen Keramikschicht und Metallschicht zu entfernen. In entsprechender Weise wird ein Strukturierungsaufwand verringert, insbesondere für zweite Bereiche, die innerhalb der Metallschicht angeordnet sind. Dabei ist unter Strukturierung insbesondere die Ausbildung von Metallabschnitten in der Metallschicht bzw. die Ausbildung eines Kantenverlaufs der Metallschicht zu verstehen. Insbesondere erfolgt die Strukturierung im zweiten Bereich.

Vorzugsweise ist es vorgesehen, dass beim bereichsweisen Anbinden der Metallschicht an die Keramikschicht die Metallschicht unstrukturiert ist. Dabei ist unter "unstrukturiert" zu verstehen, dass die Metallschicht im Wesentlichen keine durchtrennten Bereiche bzw. Freibereich (durch die Metallschicht durchgreifende Freibereich), insbesondere zur Ausbildung von einzelnen Metallabschnitten, umfasst. Als unstrukturiert wird somit auch eine Metallschicht verstanden, die an der Ober und/oder Unterseite einen rückspringen Verlauf aufweist, sofern kein Freibereich in die Metallschicht eingelassen ist. Ferner ist unter unstrukturiert vorzugsweise gemeint, dass Kantenverläufe der Metallschicht an den jeweiligen Seiten geradlinig verlaufen, d. h. ohne Vorsprünge bzw. Rücksprünge in einer parallel zur Haupterstreckungsebene verlaufende Richtung. Mit anderen Worten: Beim Anbinden weist die Metallschicht an ihrer Oberseite, d. h. an ihrer von der Keramikschicht abgewandten Seite, vorzugsweise eine geschlossene und im Wesentlichen rechteckige Oberfläche auf.

Als Materialien für die weitere Metallisierungsschicht an der Außenseite der Verkapselung bzw. der Metallisierungsschicht des Trägersubstrats sind vorstellbar Kupfer, Aluminium, Molybdän und/oder deren Legierungen, sowie Laminate wie CuW, CuMo, CuAl, AlCu und/oder CuCu, insbesondere eine Kupfer-Sandwichstruktur mit einer ersten Kupferschicht und einer zweiten Kupferschicht, wobei sich eine Korngröße in der ersten Kupferschicht von einer zweiten Kupferschicht unterscheidet. Weiterhin ist bevorzugt vorgesehen, dass die Metallisierungsschicht an der Außenseite und/oder die Metallisierungsschicht des Trägersubstrats oberflächenmodifiziert sind. Als Oberflächenmodifikation ist beispielsweise eine Versiegelung mit einem Edelmetall, insbesondere Silber und/oder Gold, oder ENIG (*"electroless nickel immersion gold"*) oder ein Kantenverguss an der ersten bzw. zweiten Metallisierungsschicht zur Unterdrückung einer Rissbildung bzw. -weitung denkbar.

Vorzugsweise weist die Keramikschicht Al₂O₃, Si₃N₄, AIN, eine HPSX-Keramik (d. h. eine Keramik mit einer Al₂O₃- Matrix, die einen x-prozentigen Anteil an ZrO₂ umfasst, beispielsweise Al₂O₃ mit 9% ZrO₂ = HPS9 oder Al₂O₃ mit 25% ZrO₂ = HPS25), SiC, BeO, MgO, hochdichtes MgO (> 90% der theoretischen Dichte), TSZ (tetragonal stabilisiertes Zirkonoxid) oder ZTA als Material für die Keramik auf. Es ist dabei auch vorstellbar, dass die Isolationsschicht als Verbund- bzw. Hybridkeramik ausgebildet ist, bei der zur Kombination verschiedener gewünschter Eigenschaften mehrere Keramikschichten, die sich jeweils in Hinblick auf ihre materielle Zusammensetzung unterscheiden, übereinander angeordnet und zu einer Isolationsschicht zusammengefügt sind. Vorzugsweise wird eine hochgradig wärmeleitfähige Keramik für einen möglichst geringen Wärmwiderstand verwendet.

Hierzu wird vorzugsweise die Metallschicht an die Isolierschicht mittels eines AMB-Verfahrens und/oder ein DCB-Verfahren stoffschlüssig angebunden.

Unter einem "DCB-Verfahren" (Direct-Copper-Bond-Technology) oder einem "DAB-Verfahren" (Direct-Aluminium-Bond-Technology) versteht der Fachmann ein solches Verfahren, das beispielsweise zum Verbinden von Metallschichten oder - blechen (z. B. Kupferblechen oder -folien oder Aluminiumblechen oder -folien) miteinander und/oder mit Keramik oder Keramikschichten dient, und zwar unter Verwendung von Metall- bzw. Kupferblechen oder Metall- bzw. Kupferfolien, die an ihren Oberflächenseiten eine Schicht oder einen Überzug (Aufschmelzschicht), aufweisen. Bei diesem beispielsweise in der US 3 744 120 A oder in der DE23 19 854 C2 beschriebenen Verfahren bildet diese Schicht oder dieser Überzug (Aufschmelzschicht) ein Eutektikum mit einer Schmelztemperatur unter der Schmelztemperatur des Metalls (z. B. Kupfers), so dass durch Auflegen der Folie auf die Keramik und durch Erhitzen sämtlicher Schichten diese miteinander verbunden werden können, und zwar durch Aufschmelzen des Metalls bzw. Kupfers im Wesentlichen nur im Bereich der Aufschmelzschicht bzw. Oxidschicht.

Insbesondere weist das DCB-Verfahren dann z. B. folgende Verfahrensschritte auf:
• Oxidieren einer Kupferfolie derart, dass sich eine gleichmäßige Kupferoxidschicht ergibt;
• Auflegen des Kupferfolie auf die Keramikschicht;
• Erhitzen des Verbundes auf eine Prozesstemperatur zwischen etwa 1025 bis 1083°C, z. B. auf ca. 1071°C;
• Abkühlen auf Raumtemperatur.

Unter einem Aktivlot-Verfahren z. B. zum Verbinden von Metallschichten oder Metallfolien, insbesondere auch von Kupferschichten oder Kupferfolien mit Keramikmaterial ist ein Verfahren zu verstehen, welches speziell auch zum Herstellen von Metall-Keramik-Substraten verwendet wird, wird bei einer Temperatur zwischen ca.650-1000°C eine Verbindung zwischen einer Metallfolie, beispielsweise Kupferfolie, und einem Keramiksubstrat, beispielsweise Aluminiumnitrid-Keramik, unter Verwendung eines Hartlots hergestellt, welches zusätzlich zu einer Hauptkomponente wie Kupfer, Silber und/oder Gold auch ein Aktivmetall enthält. Dieses Aktivmetall, welches beispielsweise wenigstens ein Element der Gruppe Hf, Ti, Zr, Nb, Ce ist, stellt durch chemische Reaktion eine Verbindung zwischen dem Lot und der Keramik her, während die Verbindung zwischen dem Lot und dem Metall eine metallische Hartlöt-Verbindung ist. Alternativ ist zur Anbindung auch ein Dickschichtverfahren vorstellbar.

Grundsätzlich ist es vorstellbar, dass der Metallabschnitt am äußersten Rand der Metallschicht nach dessen Herstellung nach oben abgeknickt und/oder in eine bevorzugte Ausrichtung orientiert wird. Besonders bevorzugt ist es allerdings vorgesehen, dass der Metallabschnitt den Verlauf der Metallschicht entlang der Haupterstreckungsebene HSE fortsetzt, und so seitlich gegenüber der Keramikschicht vorsteht. Beispielsweise ist es vorstellbar, dass der zweite Bereich während eines Anbindungsprozesses dadurch erzielt wird, dass die Metallschicht an einer Ober- und/oder Unterseite vor dem Durchführen des Anbindungsverfahrens nur partiell oxidiert ist. Dadurch bleiben beispielsweise Bereiche, vorzugsweise durch eine entsprechende Maskierung, frei von einer Oxidation, die im Anbindungsprozess erforderlich ist für die Ausbildung eines Eutektikums und damit für die Anbindung zwischen Metallschicht und Keramikschicht. Weiterhin ist es bevorzugt vorgesehen, dass der zweite Bereich zumindest zwischen zwei ersten Bereichen angeordnet ist.

Gemäß einer bevorzugten Ausführungsform der vorliegenden Erfindung ist es vorgesehen, dass zur Ausbildung eines Metallabschnitts, der im gefertigten Zustand gegenüber der Keramikschicht in einer parallel zur Haupterstreckungsebene verlaufenden Richtung zur Ausbildung eines Anschlusses oder Terminals vorsteht, der zweite Abstand größer als der erste Abstand ist. Dadurch ist es in vorteilhafter Weise möglich, ein gegenüber dem äußersten Umfang der Keramikschicht vorstehenden, lateralen Terminal bereitzustellen, der als elektrischer Anschluss für das Metall-Keramik-Substrat dienen kann. Insbesondere ist es vorgesehen, dass ein Verhältnis zwischen dem ersten Abstand zum zweiten Abstand einen Wert zwischen 0,01 und 0,1, bevorzugt zwischen 0,015 und 0,05 und, besonders bevorzugt, zwischen 0,01 und 0,04 annimmt. Vorzugsweise nimmt der erste Abstand einen Wert kleiner 1,5 mm, bevorzugt zwischen 0,1 und 0,8 mm und besonders bevorzugt zwischen 0,3 und 0,6 mm an und/oder der zweite Abstand nimmt einen Wert zwischen 3 und 50 mm, bevorzugt zwischen 4 und 20 mm und besonders bevorzugt zwischen 5 und 15 mm an. Entsprechend ist es dadurch möglich, vergleichsweise weit vorstehende Terminals bereitzustellen, die beispielsweise mit den üblichen mechanischen Abziehmethoden aus dem Stand der Technik nicht realisierbar wären. Insbesondere gestatten derart lange Terminals eine flexible Anpassung an den jeweiligen Anwendungsfall des gefertigten Metall-Keramik-Substrats und gestatten beispielsweise auch eine vollständige Ummantelung des hergestellten Metall-Keramik-Substrates in einem Gehäuse, aus dem der hergestellte Metallabschnitt seitlich als Anschluss herausragen kann.

In einer bevorzugten Ausführungsform der vorliegenden Erfindung ist es vorgesehen, dass vor dem Verbinden ein senkrecht zur Haupterstreckungsebene HSE bemessener dritter Abstand zwischen der Metallschicht und der Keramikschicht im zweiten Bereich realisiert wird. Dadurch wird sichergestellt, dass durch den entsprechenden dritten Abstand zwischen der Keramikschicht und der Metallschicht eine Verbindung bzw. Anbindung im späteren zweiten Bereich während des Anbindungsverfahrens verhindert wird, und somit der zweite Bereich realisiert wird. Vorzugsweise ist es vorgesehen, dass ein Verhältnis eines dritten Abstandes zu einer entlang der Stapelrichtung bemessenen Dicke der Metallschicht einen Wert zwischen 0,05 und 0,7, bevorzugt zwischen 0,1 und 0,45 und, besonders bevorzugt zwischen 0,15 und 0,35 annimmt. Weiter ist es vorgesehen, dass der dritte Abstand einen Wert zwischen 10 und 500 µm annimmt, bevorzugt zwischen 10 und 150 µm und besonders bevorzugt zwischen 10 und 80 µm. Die Metallschicht weist hingegen vorzugsweise eine Dicke zwischen 200 und 1000 µm, bevorzugt zwischen 200 und 600 µm und besonders bevorzugt zwischen 200 und 400 µm auf. Dadurch wird auf der einen Seite sichergestellt, dass eine ausreichende Beabstandung der Metallschicht im zweiten Bereich vorliegt, und gleichzeitig eine ausreichende Dicke für die Metallschicht, die sich als funktionsfähiger Anschluss eignet, bereitgestellt wird.

Zweckmäßigerweise ist es bevorzugt vorgesehen, dass der dritte Abstand durch ein Anätzen vor dem Zusammenfügen der Metallschicht und der Keramikschicht realisiert wird. Insbesondere ist der dritte Abstand festgelegt durch eine Ätztiefe, die während eines Anätzens realisiert wird. Insbesondere versteht der Fachmann unter einem Anätzen einen derartigen Ätzprozess, der derart gesteuert und kontrolliert ist, dass er unterbrochen wird, bevor die Metallschicht durchgeätzt ist. Insbesondere wird der Ätzprozess so gesteuert, dass eine Aussparung in der Metallschicht realisiert wird mit einer Ätztiefe, die dann dem späteren dritten Abstand entspricht, wenn die Metallschicht auf die Keramikschicht gelegt wird, bevor die Anbindung, insbesondere über ein DCB-Verfahren, erfolgt.

Es ist weiterhin vorstellbar, dass der dritte Abschnitt durch eine Strukturierung bzw. Einätzung in der Keramikschicht bereitgestellt wird. In diesem Fall kann man unter Umständen auf ein entsprechendes Anätzen in der Metallschicht verzichten.

Ein derartiges Vorgehen erweist sich insbesondere als vorteilhaft für Keramikschichten mit einer vergleichsweise großen, in Stapelrichtung bemessenen, Dicke, und/oder solche Metall-Keramik-Substrate, die eine vergleichsweise geringe Metallschichtdicke im ersten Bereich des gefertigten Prozesses aufweisen sollen.

Weiterhin ist es bevorzugt vorgesehen, dass der dritte Abstand zwischen der Metallschicht und der Keramikschicht durch eine Pufferschicht und/oder ein Aktivlot- bzw. ein Lotmaterial realisiert wird. Insbesondere bei der Herstellung mittels eines Aktivlotmaterials erfolgt das Anbinden der Metallschicht an die Keramikschicht über einen Lötvorgang. Dabei ist es erforderlich, dass vor dem Lötverfahren das Lötmaterial nur partiell auf der Keramikschicht und/oder die Metallschicht aufgetragen wird. Insbesondere wird mittels einer entsprechenden Maskierung dafür gesorgt, dass das Lotmaterial nur in gezielten Bereichen aufgetragen wird, die später die ersten Bereiche bilden. Alternativ ist es vorstellbar, dass statt eines Aktivlotmaterials bzw. Lotmaterials gezielt eine Pufferschicht aufgetragen wird, wobei die Pufferschicht vorzugsweise aus einem Pulvergemisch besteht, das Keramikpartikel und/oder Glasparitkel und Metallpartikel umfasst. Insbesondere handelt es sich dabei um ein Pulver aus Komposit- bzw. Verbundpartikeln, bei denen durch eine entsprechende Vorbehandlung die Partikel aus Keramik und die Partikel auf Metall zu einem Mischpartikel zusammengeschweißt, zusammengeschmolzen bzw. zusammengefügt sind. Vorzugsweise wird ein entsprechendes Puffermaterial bzw. Material für die Pufferschicht durch Mechanofusion hergestellt. Mittels einer derartigen Pufferschicht kann zusätzlich für einen entsprechenden Angleich der thermischen Ausdehnungskoeffizienten zwischen Keramikschicht und Metallschicht gesorgt werden, und gleichzeitig für eine ausreichende Beabstandung zwischen der Metallschicht und der Keramikschicht, d. h. für den dritten Abstand. In einer weiteren Ausführungsform ist es vorgesehen, dass das Aktivlotmaterial zur Ausbildung des ersten Bereichs und zweiten Bereichs nur teilweise auf die Metallschicht und/oder Keramikschicht aufgetragen wird.

Vorzugsweise ist es vorgesehen, dass zum Auftrennen der Keramikschicht eine Sollbruchstelle realisiert wird. Beispielsweise wird diese Sollbruchstelle im zweiten Bereich mittels einer Laserbehandlung oder Laserstrahlung realisiert. Es ist allerdings auch vorstellbar, dass eine derartige Sollbruchstelle durch ein mechanisches Verfahren, wie Ritzen und/oder Fräsen und/oder Ätzen fertiggestellt wird. Die Sollbruchstelle, die sich durchgehend und/oder unterbrochen entlang einer Richtung erstrecken kann, legt somit den ersten Abstand zwischen dem ersten Bereich und der Stelle des Auftrennens der Keramikschicht fest. Vorzugsweise wird demnach die Keramikschicht zum Auftrennen aufgebrochen bzw. abgebrochen. Dadurch lässt sich in vorteilhafter Weise für das Auftrennen der Keramikschicht eine gezielte Einstellung des ersten Abschnitts realisieren.

In einer weiteren Ausführungsform ist es vorgesehen, dass zum Auftrennen der Metallschicht ein Ätzverfahren verwendet wird. Hierzu wird vorzugsweise eine erneute Resistschicht auf die bereits an die Keramikschicht angebundene Metallschicht aufgetragen, und im Gegensatz zu dem Anätzen, welches zur Ausbildung des dritten Abstands genutzt wird, wird die Metallschicht dann vollständig durchgeätzt, sodass ein Auftrennen der Metallschicht erfolgt. Dadurch lässt sich gezielt der zweite Abstand für das Auftrennen der Metallschicht im zweiten Bereich festlegen.

In einer weiteren Ausführungsform der vorliegenden Erfindung ist es vorgesehen, dass das Metall-Keramik-Substrat eine Großkarte ist. Insbesondere ist es vorgesehen, dass die Metall-Keramik-Substrate mit den Terminals in einer Großkartenform hergestellt werden und durch entsprechendes Auftrennen voneinander mehrere Einzel-Metall-Keramik-Substrate mit jeweiligem Terminal bereitgestellt werden. Mit anderen Worten: Die Herstellung als Großkarte ermöglicht die Mehrfachnutzungsfertigung. Ein entsprechendes Verfahren erweist sich insbesondere gegenüber den aus dem Stand der Technik bekannten Streifenverfahren als vorteilhaft, die vergleichsweise aufwändig zu automatisieren sind. Insbesondere lassen sich mehrere Metall-Keramik-Substrate mit Terminals zeitgleich herstellen, die durch das Auftrennen der Metallschicht und der Keramikschicht entstehen.

Ein weiterer Gegenstand der vorliegenden Erfindung ist ein Metall-Keramik-Substrat, das mit dem erfindungsgemäßen Verfahren hergestellt wurde, wobei die Metallschicht im zweiten Bereich insbesondere kleiner ist als im ersten Bereich. Alle für das Verfahren beschriebenen Eigenschaften und Vorteile gelten analog für das Metall-Keramik-Substrat und anders herum.

Vorzugsweise weist das gefertigte Metall-Keramik-Substrat einen zweiten Bereich auf, d. h. es gibt einen Teilbereich im gefertigten Metall-Keramik-Substrat, in dem die Metallschicht und die Keramikschicht ohne stoffschlüssige Bindung zueinander übereinander in Stapelrichtung gesehen angeordnet sind.

Weitere Vorteile und Merkmale ergeben sich aus der nachfolgenden Beschreibung bevorzugter Ausführungsformen des erfindungsgemäßen Gegenstands mit Bezug auf die beigefügten Figuren. Einzelne Merkmale der einzelnen Ausführungsformen können dabei im Rahmen der Erfindung miteinander kombiniert werden.

Es zeigt:
- **Fig.1a bis 1g:**: schematisch ein Verfahren zur Herstellung eines Metall-Keramik-Substrats gemäß einer ersten bevorzugten Ausführungsform der vorliegenden Erfindung und
- **Fig.2a bis 2g:**: schematisch ein Verfahren zur Herstellung eines Metall-Keramik-Substrats gemäß einer zweiten bevorzugten Ausführungsform der vorliegenden Erfindung.

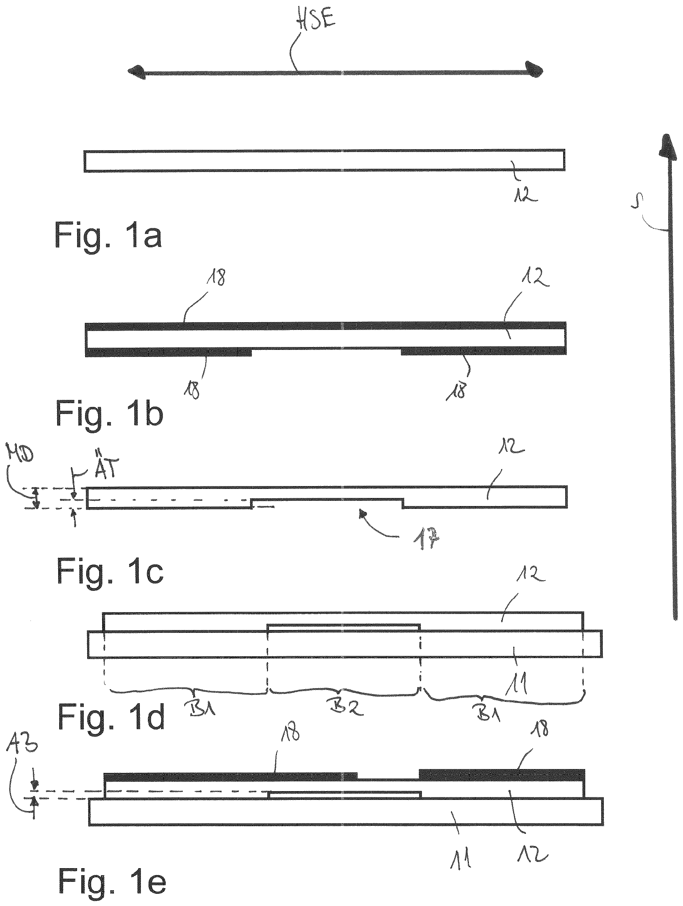

In den **Figuren 1a bis1g** ist schematisch ein Verfahren zur Herstellung eines Metall-Keramik-Substrats 1 gemäß einer ersten bevorzugten Ausführungsform der vorliegenden Erfindung dargestellt. Solch ein Metall-Keramik-Substrat 1 dient vorzugsweise jeweils als Träger von elektronischen bzw. elektrischen Bauteile, die an das Metall-Keramik-Substrat 1 anbindbar sind. Wesentliche Bestandteile eines solchen Metall-Keramik-Substrats 1 sind eine sich entlang einer Haupterstreckungsebene HSE erstreckende Keramikschicht 11 und eine an der Keramikschicht 11 angebundene Metallschicht 12. Die Keramikschicht 11 ist aus mindestens einem eine Keramik umfassenden Material gefertigt. Die Metallschicht 12 und die Keramikschicht 11 sind dabei entlang einer senkrecht zur Haupterstreckungsebene HSE verlaufenden Stapelrichtung S übereinander angeordnet und in einem gefertigten Zustand über eine Anbindungsfläche A zumindest bereichsweise miteinander stoffschlüssig verbunden. Vorzugsweise wird die Metallschicht 12 dann zur Bildung von Leiterbahnen oder Anbindungsstellen für die elektrischen Bauteile strukturiert. Beispielsweise wird diese Strukturierung in die Metallschicht 12 eingeätzt. Im Vorfeld muss allerdings eine dauerhafte Bindung, insbesondere stoffschlüssige Anbindung, zwischen der Metallschicht 12 und der Keramikschicht 11 gebildet werden.

Um die Metallschicht 12 dauerhaft an die Keramikschicht 11 anzubinden, umfasst eine Anlage zur Herstellung des Metall-Keramik-Substrats 1, insbesondere in einem DCB oder DAB - Anbindungsverfahren, einen Ofen, in dem ein gestapelte Anordnung aus einer Keramikschicht 11 und mindestens einer Metallschicht 12 erhitzt wird und so die Bindung erzielt wird. Beispielsweise handelt es sich bei der Metallschicht 12 um eine aus Kupfer gefertigte Metallschicht 12, wobei die Metallschicht 12 und die Keramikschicht 11 mit einem DCB (Direct-Copper-Bonding) - Anbindungsverfahren miteinander verbunden werden.

Insbesondere betrifft das Verfahren die Herstellung von Metall-Keramik-Substraten 1, die einen seitlich bzw. lateral abstehenden Anschluss bzw. Terminal 5 aufweisen. Unter einem Terminal 5 ist insbesondere ein Metallabschnitt zu verstehen, der sich in einer parallel zur Haupterstreckungsebene HSE verlaufenden Richtung über eine Randseite, insbesondere eine äußerste Randseite der Keramikschicht 11 hinaussteht und somit gegenüber der Keramikschicht 11 in einer parallel zur Haupterstreckungsebene HSE verlaufenden Richtung vorsteht. Ein solcher seitlich bzw. lateral hervorstehender Metallabschnitt bildet einen Anschluss bzw. Terminal 5, über den die Metallschicht 12 elektrisch kontaktiert werden kann. Hierzu ist es insbesondere vorgesehen, dass der Metallabschnitt Teil der Metallschicht 12 ist, die an einer Seite der Keramikschicht 11 über die Anbindungsfläche A direkt angebunden ist. Zur Ausbildung derartiger Metall-Keramik-Substrate 1 wird zunächst eine Metallschicht 12 bereitgestellt. In dem in den Figuren 1a bis 1g dargestellten Verfahren ist es dabei vorgesehen, dass auf die Metallschicht 12, insbesondere auf eine Ober- und/oder Unterseite der Metallschicht 12, eine Resistschicht 18 zumindest teilweise aufgetragen wird. Insbesondere ist es vorgesehen, dass die Resistschicht 18 an der Ober- und/oder Unterseite bereichsweise aufgetragen ist, sodass zumindest ein Teilabschnitt an der Unter- und/oder Oberseite der Metallschicht 12 frei bleibt von der Resistschicht 18. In dem in Figur 1b dargestellten Ausführungsbeispiel ist die Oberseite der Metallschicht 12 vollständig mit der Resistschicht 18 bedeckt, während auf der Unterseite die Resistschicht 18 derart aufgetragen ist, dass in einem mittleren Bereich, d. h. zwischen zwei Teilbereichen mit Resistschicht 18, ein Teilbereich vorliegt, der frei ist von der Resistschicht 18. Derartige Resistschichen 18 dienen dazu, während eines Ätzvorganges mit einem Ätzmittel zu verhindern, dass ein Ätzen in den von der Resistschicht 18 bedeckten Bereichen stattfindet.

Im Gegensatz zu den mit der Resistschicht 18 bedeckten Bereichen, werden die Bereiche, die frei sind von der Resistschicht, in einem Ätzschritt geätzt. Insbesondere ist hierbei ein Anätzen vorgesehen, d. h. das Ätzen wird derart konfiguriert oder eingestellt, dass der Ätzprozess gestoppt bzw. unterbrochen wird, bevor die Metallschicht 12 vollständig durch den Ätzprozess in einer parallel zur Stapelrichtung S verlaufenden Richtung durchdrungen ist. Insbesondere ist es vorgesehen, dass der Ätzprozess derart eingestellt ist, dass der Ätzprozess beendet ist, sobald eine Aussparung 17 mit einer Ätztiefe ÄTan der Unterseite ausgeformt ist, wobei die Ätztiefe ÄT, insbesondere die in Stapelrichtung S bemessene Ätztiefe ÄT, kleiner ist als eine in Stapelrichtung S bemessene Metallschichtdicke MD. Vorzugsweise ist es vorgesehen, dass ein Verhältnis der Metallschichtdicke MD, insbesondere gemessen in einem der Bereiche, der zuvor mit der Resistschicht 18 bedeckt wurde, zu einer Ätztiefe ÄT einen Wert zwischen 1,5 und 15, bevorzugt zwischen 2 und 10 und, besonders bevorzugt, zwischen 2,5 und 7 annimmt. Hierdurch wird zum einen eine ausreichende Tiefe für die Aussparung 17 realisiert und, gleichzeitig, eine ausreichende Dicke des späteren Metallabschnitts, der im gefertigten Produkt den lateral abstehenden Terminal 5 bildet.

Insbesondere ist es vorgesehen, dass im Anschluss an den Ätzvorgang bzw. an das Anätzen, die Metallschicht 12 an die Keramikschicht 11 angebunden wird, insbesondere mittels eines Metalldirektanbindungsverfahrens. Dabei ist es vorgesehen, dass die die Aussparung 17 aufweisende Seite bzw. Ober- und Unterseite der Metallschicht 12 der Keramikschicht 11 zugewandt ist, d. h. zwischen der Metallschicht 12 und der Keramikschicht 11 formt sich in einem zweiten Bereich B2 ein Hohlraum aus, in dem die Metallschicht 12 gegenüber der Keramikschicht 11 um einen dritten Abstand A3 beabstandet ist. Während des Anbindungsverfahrens, bei dem die Metallschicht 12 an die Keramikschicht 11 angebunden wird, bilden sich somit erste Bereiche B1 aus, in denen die Metallschicht 12 stoffschlüssig in Verbindung zu der Keramikschicht 11 steht, insbesondere über eine Anbindungsfläche A. Zwischen zwei ersten Bereichen B1 wird insbesondere dann ein zweiter Bereich B2 ausgeformt, in dem die Metallschicht 12 und die Keramikschicht 11 ohne stoffschlüssige Verbindung in Stapelrichtung S gesehen übereinander angeordnet sind. Mit anderen Worden: im zweiten Bereich B2 erfolgt dabei keine Anbindung der Metallschicht 12 an die Keramikschicht 11, insbesondere hervorgerufen durch den in Figur 1b gezeigten Verlauf der Ober- und Unterseite mit der Aussparung 17, die für eine ausreichende Beabstandung der Metallschicht 12 zu der Keramikschicht 11 sorgt.

Nach dem Anbinden der Metallschicht 12 an die Keramikschicht 11 ist es vorgesehen, dass auf die Oberseite der Metallschicht 12 erneut eine Resistschicht 18 aufgetragen wird. Insbesondere ist es vorgesehen, dass in diesem Fall die Resistschicht 18 derart aufgetragen wird, dass sie an der Oberseite unterbrochen ist. Dabei ist eine derartige Unterbrechung im zweiten Bereich B2 vorgesehen. Durch ein Ätzen nach dem Auftragen der Resistschicht 18 ist es dann möglich, die Metallschicht 12 im zweiten Bereich B2 in einem parallel zur Haupterstreckungsebene HSE bemessenen zweiten Abstand A2 vom ersten Bereich B1 aufzutrennen. Dabei ist es insbesondere vorgesehen, dass durch die Anordnung der Resistschicht 18 im vorangehenden Schritt der zweite Abstand A2, und damit die Länge des späteren Terminals 5 entlang der Haupterstreckungsebene HSE, festgelegt wird.

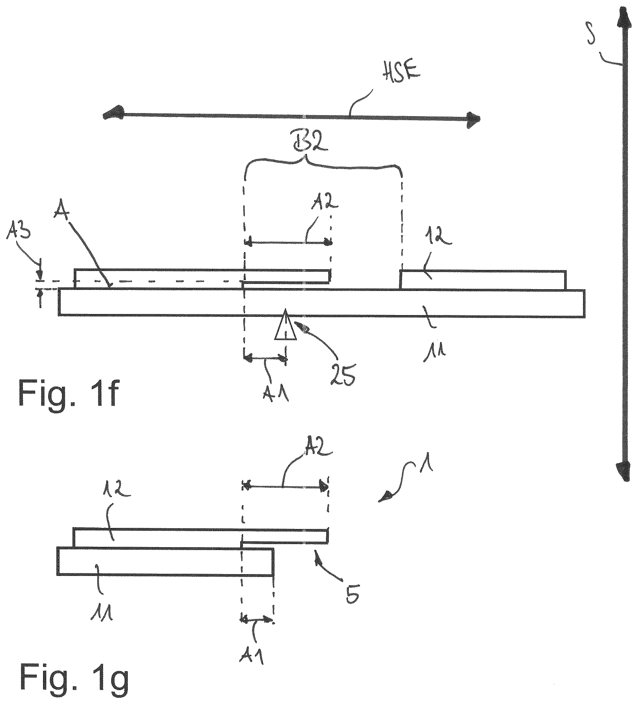

Insbesondere erweist sich dies insofern als vorteilhaft, als dass dadurch vergleichsweise lange Terminals 5 hergestellt werden können. Insbesondere im Vergleich zu solchen Terminals 5, die, wie im Stand der Technik üblich, durch ein mechanisches Abziehen entstehen. Schließlich ist es vorgesehen, dass nach dem Auftrennen der Metallschicht 12 eine Sollbruchstelle 25 im zweiten Bereich B2 in der Keramikschicht 11 realisiert wird (Fig. 1f). Insbesondere ist die Sollbruchstelle 25 in einem ersten Abstand A1 vom ersten Bereich B1 in einer parallel zu Haupterstreckungsebene HSE verlaufenden Richtung angeordnet. Durch ein Auftrennen, insbesondere Aufbrechen bzw. Brechen der Keramikschicht 11 an der Sollbruchstelle 25, erfolgt ein Auftrennen der Keramikschicht 11 in einem ersten Abstand A1 zum ersten Bereich B1. Insbesondere ist es vorgesehen, dass der erste Abstand A1 kleiner ist als der zweite Abstand A2, sodass sich ein gegenüber dem Rand der Keramikschicht 11 vorstehender Metallabschnitt in der Metallschicht 12 ausbildet, der als Anschluss bzw. Terminal 5 geeignet ist. Dadurch wird in einfacher und produktionssicherer Weise ein Metall-Keramik-Substrat 1 mit lateral vorstehenden Terminal 5 realisiert.

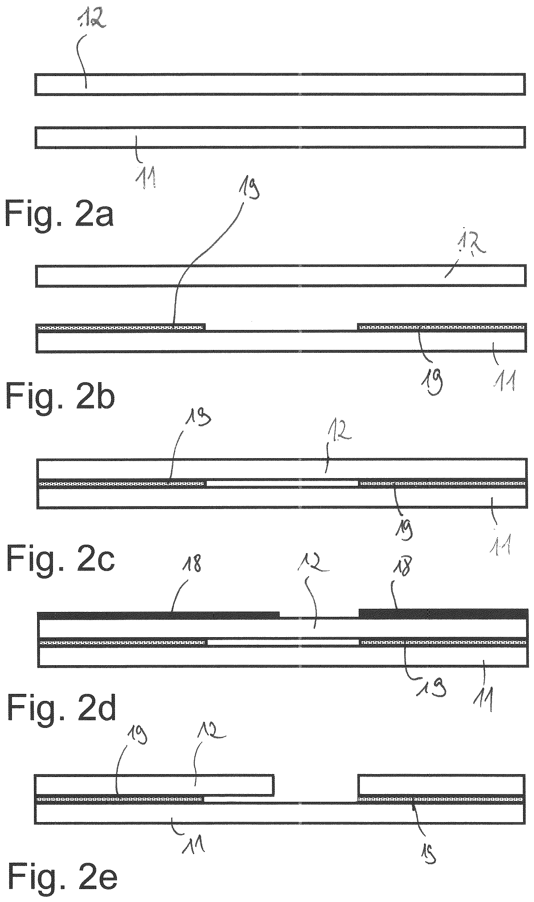

In den **Figuren 2a bis 2g** ist ein Verfahren gemäß einer weiteren bevorzugten Ausführungsform der vorliegenden Erfindung dargestellt. Insbesondere unterscheidet sich das Verfahren in den Figuren 2a bis 2g im Vergleich zu dem in den Figuren 1a bis 1g dargestellten Verfahren dahingehend, dass zur Anbindung der Metallschicht 12 ein Lotmaterial 19 vorgesehen ist. Entsprechend ist es vorgesehen, dass in einem ersten Schritt, die Metallschicht 11 und die Keramikschicht 12 bereitgestellt werden. Anschließend wird bereichsweise auf die Keramikschicht 12 ein Lotmaterial 19 aufgetragen. Insbesondere wird dies derart aufgetragen, dass zwischen zwei Bereichen mit Lotbeschichtung bzw. -material 19 ein Bereich angeordnet ist, der frei von einem Lotmaterial 19 ist. Anschließend werden die Keramikschicht 11 und die Metallschicht 12 in Stapelrichtung S gesehen übereinander angeordnet, insbesondere so, dass die Metallschicht 12 und die Keramikschicht 11 über das Lotmaterial 19 in Verbindung stehen, und der zwischen den Lotschichten aus dem Lotmaterial 19 frei gebliebene Bereich ohne Lotmaterial 19 eine ausreichende Beabstandung (d. h. dritten Abstand A3) zwischen der Metallschicht 12 und der Keramikschicht 11 sicherstellt, sodass bei einem Aktivlöten über das Lotmaterial 19 keine Anbindung im zweiten Bereich B2 des hergestellten Metall-Keramik-Substrats 1 realisiert wird.

Alternativ zur Ausbildung bzw. Anbindung der Metallschicht 12 über die Keramikschicht 11 über ein beabstandendes Lotmaterial 19 ist es auch vorstellbar, dass eine Pufferschicht anstatt des Lotmaterials 19 verwendet wird, wobei während eines Direktmetallanbindungsverfahrens, insbesondere eines DCB-Verfahrens, eine Anbindung über diese Pufferschicht erfolgt.

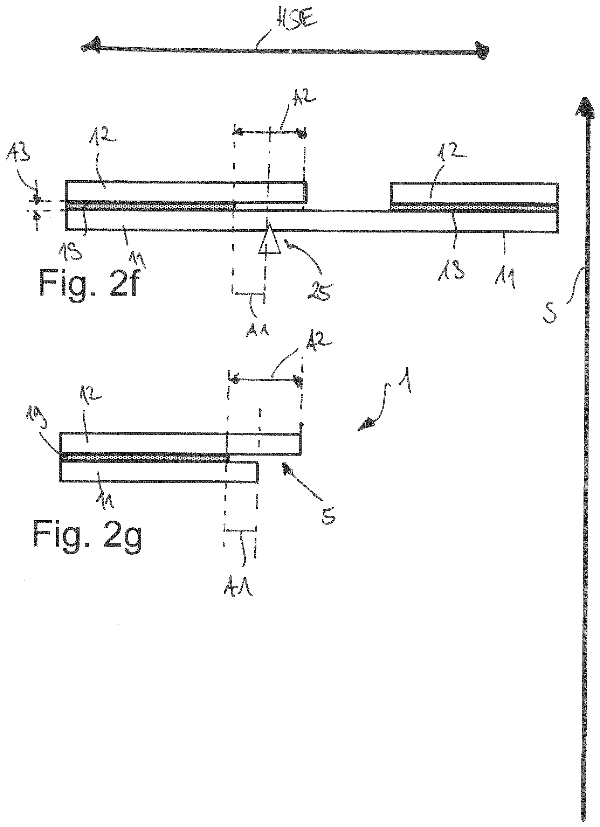

Weiterhin ist es vorstellbar, Stoppelemente an den Rand des Lotmaterials anzuordnen, um zu verhindern, dass das Lotmaterial 19 während des Anbindungsprozesses in den zweiten Bereich B2 hineinläuft, um dort ungewollt eine Anbindung zwischen Metallschicht 12 und Keramikschicht 11 zu realisieren. Die anschließenden Verfahrensschritte der Figuren 2e, 2f und 2g entsprechen im Wesentlichen denjenigen der Figuren 1e, 1f und 1g und sehen das Auftrennen der Metallschicht 12 und der Keramikschicht 11 im zweiten Bereich B2 vor.

Weiterhin ist es in einer bevorzugten Ausführungsform vorgesehen, dass die Metallschicht vor dem Anbinden über das Lotmaterial 19 bzw. die Pufferschicht, angeätzt wird. Dadurch lässt sich in vorteilhafter Weise eine Strukturierung an der Metallschicht 12 vornehmen, die ein Unterbinden der Anbindung im zweiten Bereich B2 unterstützt. Insbesondere lässt sich dadurch vermeiden, dass aufgeschmolzenes versehentlich in den geplanten zweiten Bereich B gelangtes Lotmaterial 19 dort für eine Anbindung sorgt.

Alternativ und/oder ergänzend ist es vorgesehen, ein Abstandshalter und/oder Sperrelement zu realisieren, der und/oder das verhindert, dass aufgeschmolzenes Lotmaterial 19 versehentlich in den geplanten zweiten Bereich B2 gelangt und so eine Anbindung im zweiten Bereich B2 realisiert bzw. den zweiten Bereich B2 verkleinert. In Gestalt des Abstandshalters wird beispielsweise dafür gesorgt, dass ein Abstand zwischen den zu verbindenden Schichten nicht reduziert werden kann. Dies verhindert, dass das Lötmaterial 19 aus dem ersten Bereich B1 wegen der andernfalls aufeinander zu bewegenden Schichten 11, 12, die über das Lötmaterial 19 miteinander verbunden werden sollen, in den zweiten Bereich B2 gedrängt bzw. gequetscht wird. Schließlich wäre ohne einen solchen Abstandshalter, beispielsweise wegen auftretender Kapillarkräfte, mit einem derartigen Aufeinander-zu-Bewegen der miteinander zu verbindenden Schichten zu rechnen. Dabei ist der Abstandhalter derart gestaltet, dass er an gegenüberliegenden Seiten jeweils an der Metallschicht 12 und der Keramikschicht 11 anliegt und so die Metallschicht 12 und die Keramikschicht 11 auf Abstand hält.

Beispielsweise wird hierzu ein Metall zur Ausbildung des Sperrelements und/oder Abstandhalters verwendet, das bei den herrschenden Temperaturen während der Lotanbindung nicht aufschmelzt. Ferner lässt sich mit dem Metall eine entsprechende Barriere bzw. eine Sperr- bzw. Stoppelement realisieren, das verhindert, dass Lotmaterial 19 in den geplanten zweiten Bereich B2 gelangt. Vorzugsweise erstreckt sich das Sperrelement dann entlang der Grenze zwischen dem ersten Bereich B1 und dem zweiten Bereich B2 oder ist als Platzhalter über den gesamten zweiten Bereich B2 erstreckt. Dabei ist es vorgesehen, dass das Metall derart ausgewählt ist, dass es während des Lotverfahrens keine Legierung mit dem Lotmaterial 19 bildet bzw. sich im Lotmaterial auflöst.

### Bezugszeichenliste:

- 1: Metall-Keramik-Substrat
- 5: Anschluss bzw. Terminal
- 11: Keramikschicht
- 12: Metallschicht
- 17: Aussparung
- 18: Resistschicht
- 19: Lotmaterial
- 25: Sollbruchstelle
- B1: erster Bereich
- B2: zweier Bereich
- A1: erster Abstand
- A2: zweiter Abstand
- A3: dritter Abstand
- A: Anbindungsfläche
- MD: Metallschichtdicke
- ÄT: Ätztiefe
- HSE: Haupterstreckungsebene
- S: Stapelrichtung

## Patentansprüche

1. Verfahren zur Herstellung eines Metall-Keramik-Substrats (1), das im gefertigten Zustand eine Keramikschicht (11) und eine Metallschicht (12), die sich entlang einer Haupterstreckungsebene (HSE) erstrecken und entlang einer senkrecht zur Haupterstreckungsebene (HSE) verlaufenden Stapelrichtung (S) übereinander angeordnet sind, aufweist,
umfassend
-- Bereitstellen der Metallschicht (12) und der Keramikschicht (11) und
-- bereichsweises Anbinden der Metallschicht (12) an die Keramikschicht (11) zur Ausbildung eines ersten Bereichs (B1), der eine stoffschlüssige Verbindung zwischen der Metallschicht (12) und der Keramikschicht (11) aufweist, und eines zweiten Bereichs (B2), in dem die Metallschicht (12) und die Keramikschicht (11) ohne stoffschlüssige Verbindung in Stapelrichtung (S) gesehen übereinander angeordnet sind, **dadurch gekennzeichnet, dass** der zweite Bereich (B2) zumindest bereichsweise als Anschlussfläche und/oder als Terminal bereitgestellt wird, **dadurch gekennzeichnet, dass** das Verfahren weiter umfasst:
- - Auftrennen der Keramikschicht (11) im zweiten Bereich (B2) in einem parallel zur Haupterstreckungsebene (HSE) bemessenen ersten Abstand (A1) vom ersten Bereich (B1) und
- Auftrennen der Metallschicht (12) im zweiten Bereich (B2) in einem parallel zur Haupterstreckungsebene (HSE) bemessenen zweiten Abstand (A2) vom ersten Bereich (B1).

2. Verfahren gemäß Anspruch 1, wobei der zweite Bereich (B2) ein innenliegender Metallbereich der Metallschicht (12) ist.

3. Verfahren gemäß Anspruch 2, wobei der als innenliegender Metallbereich ausgeformte zweite Bereich (B2) vollständig geschlossen ist oder eine Öffnung aufweist.

4. Verfahren gemäß einem der vorhergehenden Ansprüche, wobei durch ein Auf- oder Hochbiegen des zweiten Bereichs (B2) ein Terminal bereitgestellt wird.

5. Verfahren gemäß einem der Ansprüche 1 bis 4, wobei gleichzeitig mit dem Auftrennen der Metallschicht (12) im zweiten Bereich (B2) eine Strukturierung von der Metallschicht (12) vorgenommen wird.

6. Verfahren gemäß einem der vorhergehenden Ansprüche, wobei zur Ausbildung eines Metallabschnitts (5), der im gefertigten Zustand gegenüber der Keramikschicht (11) in einer parallel zur Haupterstreckungsebene (HSE) verlaufenden Richtung zur Ausbildung eines Terminals vorsteht, der zweite Abstand (A2) größer als der erste Abstand (A1) ist.

7. Verfahren gemäß einem der vorhergehenden Ansprüche, wobei vor dem Anbinden ein senkrecht zur Haupterstreckungsebene (HSE) bemessener dritter Abstand (A3) zwischen der Metallschicht (12) und der Keramikschicht (11) im zweiten Bereich (B2) realisiert wird.

8. Verfahren gemäß Anspruch 7, wobei der dritte Abstand (A3) durch ein Anätzen vor dem Zusammenfügen der Metallschicht (12) und der Keramikschicht (11) realisiert wird.

9. Verfahren gemäß Anspruch 8, wobei der dritte Abstand (A3) zwischen der Metallschicht (12) und der Keramikschicht (11) durch eine Pufferschicht und/oder ein Lotmaterial (19) realisiert wird.

10. Verfahren gemäß Anspruch 9, wobei das Lotmaterial zur Ausbildung des ersten Bereichs (B1) und des zweiten Bereichs (B2) nur teilweise auf die Metallschicht (12) und/oder Keramikschicht (11) aufgetragen wird.

## Claims

1. A method for producing a metal-ceramic substrate (1) which, in the produced state, has a ceramic layer (11) and a metal layer (12) extending along a main extension plane (HSE) and arranged one above the other along a stacking direction (S) perpendicular to the main extension plane (HSE),
comprising
- providing the metal layer (12) and the ceramic layer (11), and
- bonding the metal layer (12) to the ceramic layer (11) in sections to form a first region (B1) having a material bond between the metal layer (12) and the ceramic layer (11) and a second region (B2) in which the metal layer (12) and the ceramic layer (11) are arranged one above the other without a material bond as seen in the stacking direction (S), **characterized in that** the second region (B2) is provided at least in sections as a connecting area and/or as a terminal, **characterized in that** the method further comprises:
- separating the ceramic layer (11) in the second region (B2) at a first distance (A1) from the first region (B1) measured parallel to the main extension plane (HSE), and
- separating the metal layer (12) in the second region (B2) at a second distance (A2) from the first region (B1).

2. The method according to claim 1, wherein the second region (B2) is an inner metal region of the metal layer (12).

3. The method according to claim 2, wherein the second region (B2) formed as an internal metal region is completely closed in an enclosed manner or has an opening.

4. The method according to one of the preceding claims, wherein a terminal is provided by bending the second region (B2) upwards or outwards.

5. The method according to one of claims 1 to 4, wherein structuring of the metal layer (12) is performed simultaneously with the separation of the metal layer (12) in the second region (B2).

6. The method according to one of the preceding claims, wherein, in order to form a metal section (5) which, in the produced state, protrudes relative to the ceramic layer (11) in a direction parallel to the main extension plane (HSE) for the forming of a terminal, the second distance (A2) is greater than the first distance (A1).

7. The method according to one of the preceding claims, wherein, prior to bonding, a third distance (A3) measured perpendicular to the main extension plane (HSE) is created between the metal layer (12) and the ceramic layer (11) in the second region (B2).

8. The method according to claim 6, wherein the third distance (A3) is achieved by etching prior to joining the metal layer (12) and the ceramic layer (11).

9. The method according to claim 7, wherein the third distance (A3) between the metal layer (12) and the ceramic layer (11) is achieved by means of a buffer layer and/or a solder material (19).

10. Method according to claim 8, wherein the solder material for forming the first region (B1) and the second region (B2) is only partially deposited on the metal layer (12) and/or ceramic layer (11).

## Revendications

1. Procédé de fabrication d'un substrat métal-céramique (1) qui, à l'état fini, comprend une couche céramique (11) et une couche métallique (12) qui s'étendent le long d'un plan d'extension principale (HSE) et sont superposées le long d'une direction d'empilement (S) perpendiculaire au plan d'extension principale (HSE),
consistant à :
-- fournir la couche métallique (12) et la couche céramique (11), et
-- relier localement la couche métallique (12) à la couche céramique (11) pour former une première zone (B1) qui présente une liaison par coopération de matière entre la couche métallique (12) et la couche céramique (11), et pour former une deuxième zone (B2) dans laquelle la couche métallique (12) et la couche céramique (11) sont superposées, vues dans la direction d'empilement (S), sans liaison par coopération de matière,
**caractérisé en ce que** la deuxième zone (B2) est fournie au moins localement comme surface de raccordement et/ou comme terminal,
et **caractérisé en ce que** le procédé consiste en outre à :
-- séparer la couche céramique (11) dans la deuxième zone (B2) à une première distance (A1) de la première zone (B1), mesurée parallèlement au plan d'extension principale (HSE), et
-- séparer la couche métallique (12) dans la deuxième zone (B2) à une deuxième distance (A2) de la première zone (B1), mesurée parallèlement au plan d'extension principale (HSE).

2. Procédé selon la revendication 1,
dans lequel la deuxième zone (B2) est une zone métallique interne de la couche métallique (12).

3. Procédé selon la revendication 2,
dans lequel la deuxième zone (B2) formée en tant que zone métallique interne est complètement fermée ou présente une ouverture.

4. Procédé selon l'une des revendications précédentes,
dans lequel un terminal est réalisé par pliage vers le haut de la deuxième zone (B2).

5. Procédé selon l'une des revendications 1 à 4,
dans lequel une structuration de la couche métallique (12) est effectuée simultanément à la séparation de la couche métallique (12) dans la deuxième zone (B2).

6. Procédé selon l'une des revendications précédentes,
dans lequel, pour former une portion métallique (5) qui, à l'état fini, dépasse de la couche céramique (11) dans une direction parallèle au plan d'extension principale (HSE), afin de former un terminal, la deuxième distance (A2) est supérieure à la première distance (A1).

7. Procédé selon l'une des revendications précédentes,
dans lequel, avant la liaison, une troisième distance (A3) entre la couche métallique (12) et la couche céramique (11), mesurée perpendiculairement au plan d'extension principale (HSE), est réalisée dans la deuxième zone (B2).

8. Procédé selon la revendication 7,
dans lequel la troisième distance (A3) est réalisée par attaque chimique avant l'assemblage de la couche métallique (12) et de la couche céramique (11).

9. Procédé selon la revendication 8,
dans lequel la troisième distance (A3) entre la couche métallique (12) et la couche céramique (11) est réalisée par une couche tampon et/ou par un matériau à braser (19).

10. Procédé selon la revendication 9,
dans lequel, pour former la première zone (B1) et la deuxième zone (B2), le matériau à braser n'est appliqué que partiellement sur la couche métallique (12) et/ou sur la couche céramique (11).
